# EUROPEAN PATENT APPLICATION

(11) **EP 1 622 440 A1**
(43) Date of publication of application: **01.02.2006**
(21) Application number: 04425590.9
(22) Date of filing: 30.07.2004
(51) Int. Cl.: H05K 7/14

(54) **Modular electric device**

(71) Applicant: Gefran S.p.A., 25050 Provaglio d'Iseo (Brescia) (IT)
(72) Inventor: Colosio, Adriano, 25050 Provaglio d'Iseo (Brescia) (IT)
(74) Representative: Ferrari, Barbara

(57) **Abstract**

Electric device for controlling apparatuses of various types, such as systems, machines, measuring instruments, and the like, of the type intended for snap mounting on a bar (4), axially extended along a determined axis (X), and comprising a plurality of base bodies (3). Each base body is adjacent side by side supported on the bar (4) and it is provided with a seat (26) for housing an electronic board or a motherboard (27). The device also comprises a plurality of electronic modules (2,2a) for signal processing, each one being fixed on a corresponding base body (3) and electrically connected to the relative electronic board (27). The seat (26) of each base body (3) is laterally open so as to form with the seat (26) of at least one adjacent base (3) an axially passing seat (27a) for receiving and housing said electronic board (27) bridge-like extended between the base body (3) and the adjacent base body (3).

## Description

### Field of application

The present invention relates to an electric device intended for controlling various types of apparatuses, such as systems, machines, measuring instruments, and similar apparatuses.

In particular, the electric device according to the invention is of the type intended for the snap mounting on a standard bar axially extended along a determined axis, and it comprises a plurality of base bodies adjacent side by side supported on the bar, each being provided with a seat for housing an electronic board. The electric device also comprises a plurality of electronic modules for signal processing, each one being fixed to a corresponding base body and electrically connected to the electronic board.

The present invention also relates to a base body of the electric device.

### Prior art

Electric devices of the aforesaid type are already known in the field of process control and automated adjustment, which, thanks to the modular configuration, offer wide application versatility and are suitable for the process control of various automatic apparatuses, also complex.

In particular, the modular configuration provides that each electronic module is intended for performing a determined control function; in this way in the case of failure or function variation thereof, the electronic module can be replaced by another module, or simply modified without varying the configuration of the other electronic modules, and therefore, of the electric device as a whole.

Known electric devices are intended for quick mounting on a standard bar that allows the single electronic modules to be regularly placed side by side and facilitates a wall-like arrangement of the electric device.

So as to fix the electronic modules on the bar, known devices are also equipped with a plurality of base bodies, also modular, also called module-holder bodies, which are supported, side by side, on the bar.

In particular, these bodies not only act as mechanical bearing elements of the electronic modules, but also as elements for containing electronic boards, normally called motherboards or back planes, to be connected, by means of their respective connectors, to a corresponding board contained in the electronic module.

For this purpose, each base body is equipped with a seat having a pre-defined form for housing the respective motherboard.

In this manner an electric device can be obtained wherein each electronic module is intended for being univocally mounted in a determined position on the bar, for being connected to its own motherboard and thus performing its function.

Known electric devices, although having the aforesaid advantages of the modular configuration, have a recognised drawback, which has not been overcome yet.

The drawback lies in that, exactly to guarantee the function distinction and exclusivity of the single electronic modules, both the configuration of the electric connections of each electronic module with the relative motherboard, and the interconnections between the various modules are substantially pre-defined, and this ties and limits the possibility of varying the applications of the device itself.

This results in fact in a considerable limitation in the use of the same modules and of the same base bodies for different applications, since this would require a variation of all the existing electric connections with the addition of suitable cables and connectors, this being too expensive.

This drawback is particularly evident in the case wherein the single electronic modules, originally electrically and functionally independent, must be interconnected at a later time. This modification inevitably determines a variation in the organisation of the connections between the motherboards and the boards associated with the electronic modules.

Moreover, the coupling between the modules normally requires complex assembly operations that limit the variations of the function combinations passed on a given device.

The technical problem underlying the present invention is that of realising an electric device of the aforesaid type, which overcomes the drawback of known electric devices.

### Summary of the invention.

The technical problem is solved by means of an electric device of the aforesaid type wherein the seat of each base body is laterally open so as to form, together with the seat of at least one adjacent base body, a seat axially passing for receiving and housing a electronic board being bridge-like or commanding extended between the base body and at least one adjacent base body.

The technical problem is also solved by a base body for a modular electric device as defined in claim 10.

Further characteristics and advantages of the electrical device according to this invention will be apparent from the following description, of an embodiment thereof given by way of indicative and non-limiting example with reference to the appended drawings.

### Brief description of the drawings.

figure 1 is a bottom perspective view of an electrical device according to the invention;

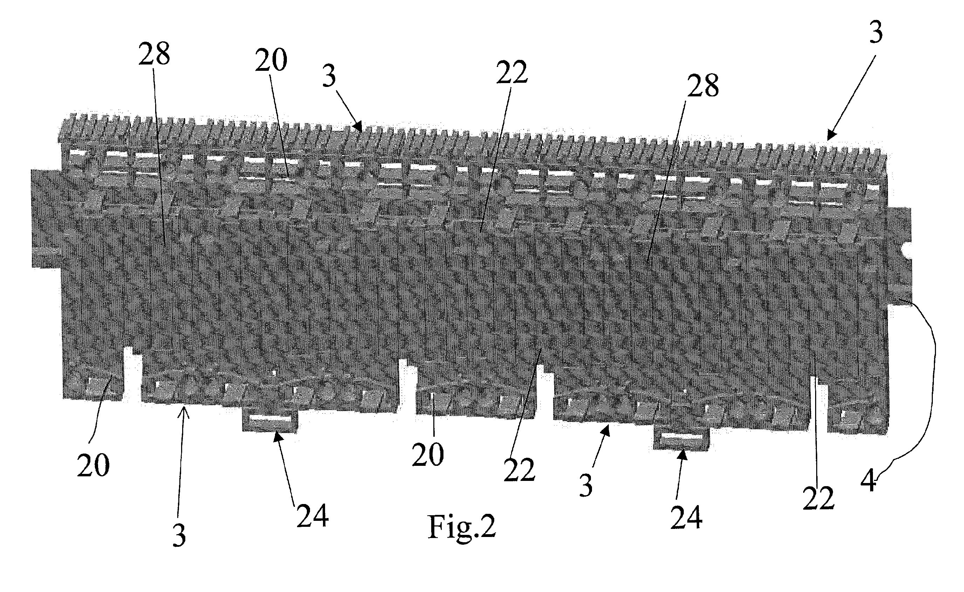

figure 2 is a view of a plurality of base bodies with a relative motherboard of the electric device of figure 1;
figure 3 is a bottom perspective view of the device according to the invention in a configuration comprising a lower number of modules;
figure 4 is a further perspective view of the device according to the invention and comprising two modules only;
figure 5 is a perspective view of a pair of base bodies with a relative motherboard for the electric device of figure 3;
figure 6 is a perspective view of the base body illustrated with increased luminosity;
figure 6a is a further perspective view of the base body of figure 6;
figure 7 is a perspective view of the base body of figure 6 completed with a motherboard;
figure 8 is a perspective view of the base body of figure 7 further completed with a protection casing;
Figure 9 is a perspective view of a complete base body;
Figure 10 is a rear view of the base body of figure 9;
Figure 11 is a perspective view of an electronic module of the device of figure 1 in disassembled condition;
Figure 12 is a view of the module of figure 11 in the assembled condition.

### Detailed description.

With reference to the annexed figures an electric device according to the invention is globally indicated with number 1.

The electric device 1 is intended for a quick snap mounting on a bar 4, in the specific case a standard omega or DIN module bar, which is axially extended along an axis X. The device 1 comprises a plurality of base bodies 3, adjacent side by side supported on the bar 4 and a plurality of electronic modules 2, each one being fixed to a corresponding base body 3.

In the case of the illustrated solutions, each base body 3 is arranged for the attachment of a pair of electronic modules 2.

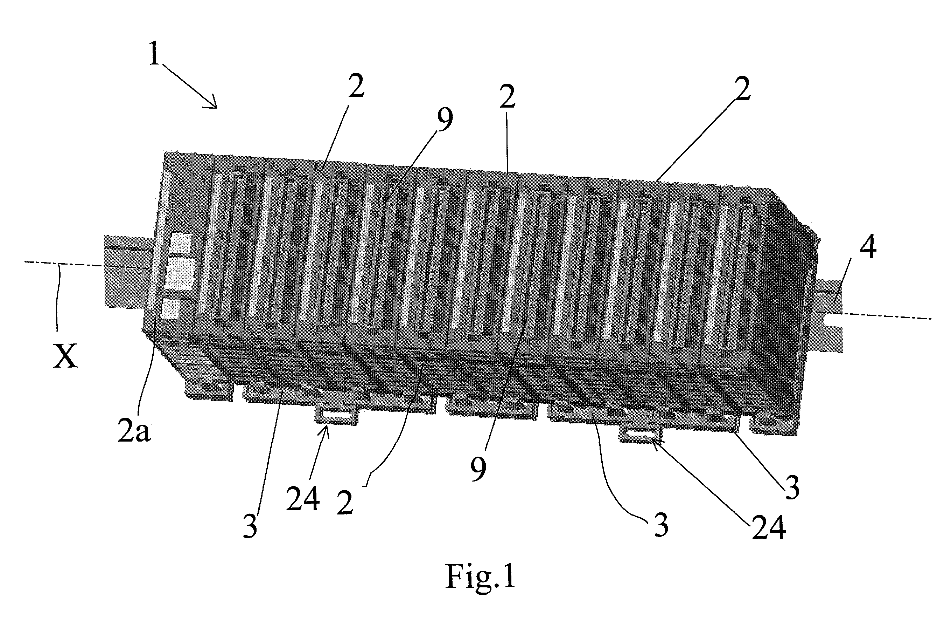

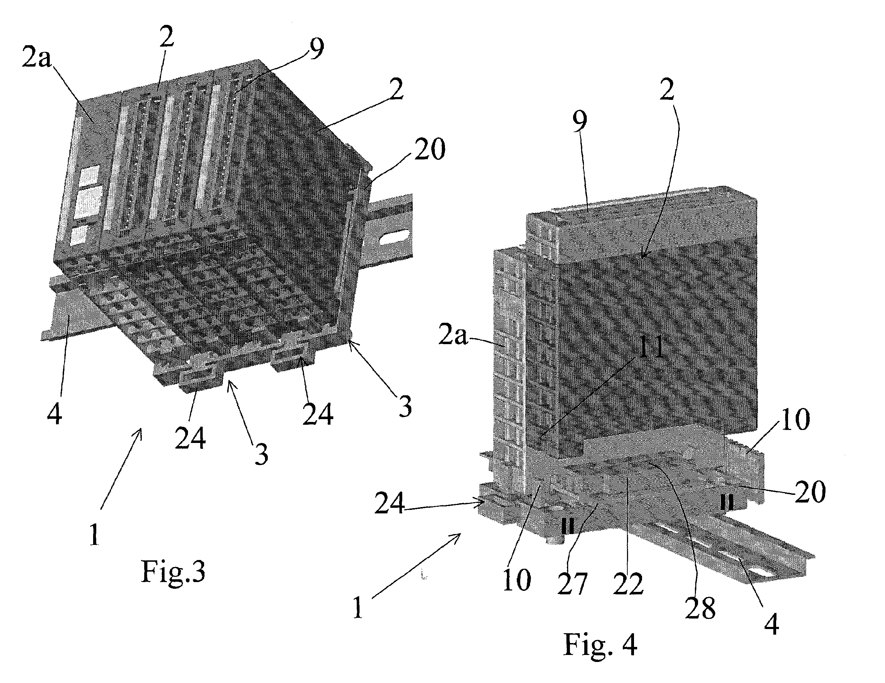

In particular, in the embodiment illustrated herein by way of indicative and non limiting example, the electric device 1 of figure 1 comprises twelve electronic modules 2, the device of figure 3 comprises four electronic modules 2, while the device of figure 4 comprises two electronic modules 2.

The bar 4, and therefore the whole electric device 1, are conventionally wall-like mounted; for this reason and for convenience of illustration, hereafter in the description all space references, such as lower, upper, frontal and the like are to be considered, by mere way of example, with reference to the wall-like position of the electric device 1.

In the electric device 1 the single electronic modules 2 have a box-like shape and they are snappily attached, in a removable way, to a corresponding housing of a base body 3. The quick attachment is obtained by coupling teeth 10 in corresponding cavities 11 (figure 4) made on the electronic modules 2.

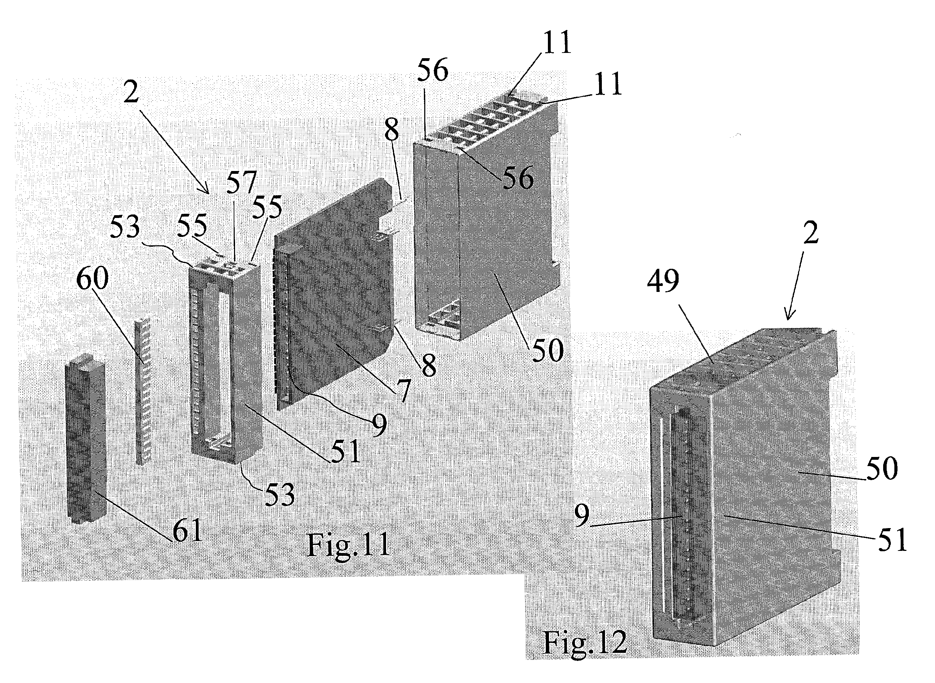

Each electronic module 2 (figures 11 and 12) comprises an electronic board 7, first connectors 8 which emerge on a rear side, i.e. the one facing the base bodies 3, and second connectors 9, which emerge on a front side, opposite to the rear one.

The electronic board 7 with the relative connectors 8 and 9 is of the known type and therefore it must not be considered limitative within the present invention. For example, in the illustrated solutions, each board 7 of the electronic modules 2 is intended for a determined control function, while the board of an electronic module 2a, also referred to as master module, is predetermined for checking and controlling all the other electronic modules 2.

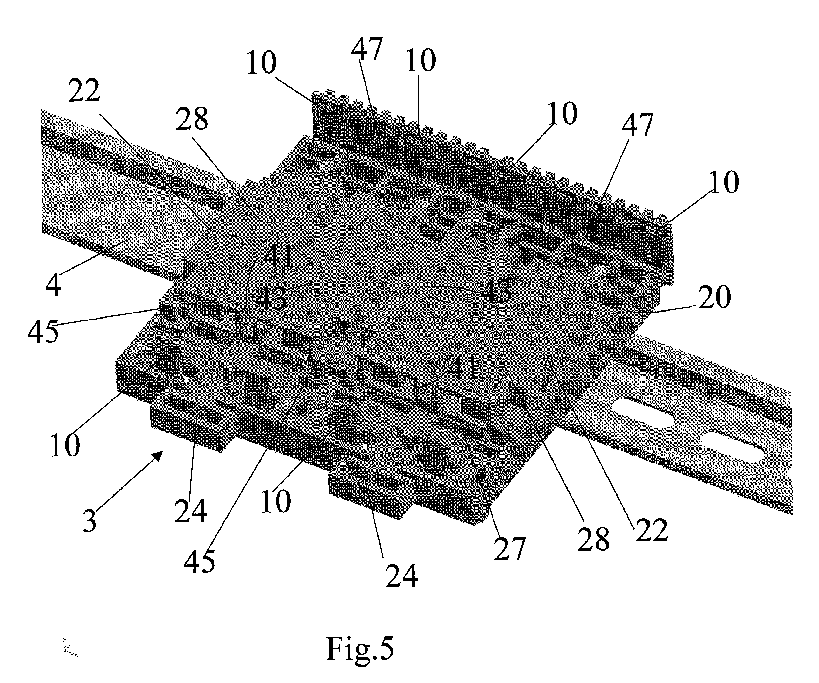

Each base body 3 is preferably of the modular type (figures 5-9) and it comprises, in the specific case, a plate 20, a protection and blocking casing 22 in place of a motherboard 27 and a slide 24 for fixing to the bar 4.

All the main components of the base body 3 are realised with plastic material.

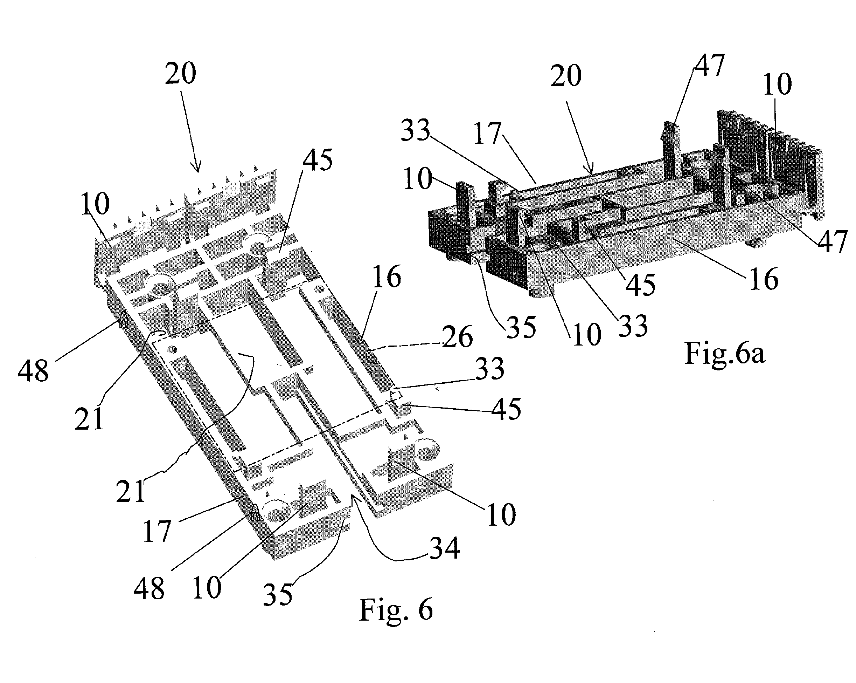

The plate 20 (fig. 6 and 6a) has a rectangular profile, so that it can be placed side by side and parallelly tied to the other plates 20 along adjacent sides 16 and 17. Advantageously, tenon-like coupling elements 46 are provided on a side of the plate 20 whereas conjugated mortise coupling elements 48 are provided on the other side for allowing an easy coupling between adjacent sides of plates 20 with relevant tie.

The plate 20 also has a plurality of cavities 21, which, besides allowing the lightening of the whole structure 3, also allow a greater dispersion of the heat during the operation of the electric device 1.

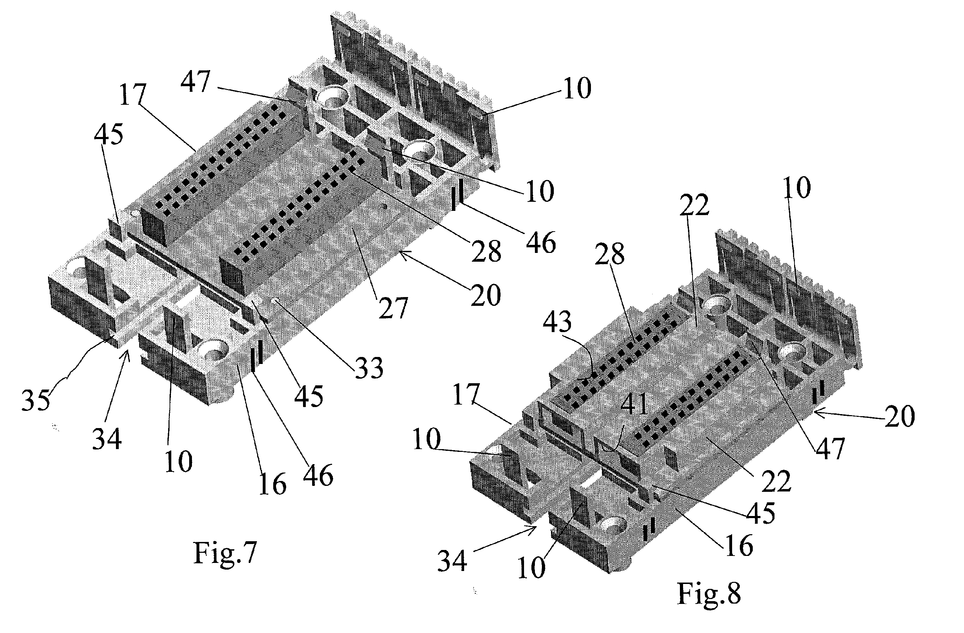

In the plate 20 a seat 26 is also made, which is indicated by a dot line in figure 6, for housing a single electronic broad, in the specific case a motherboard 27 or black plane (fig. 7), which is provided of plural connectors 28 according to the number of base bodies 3 it is intended to cover. These connectors 28 frontally overhang for being electrically connected with the first connectors 8 of the electronic modules 2.

According to a characteristic of the present invention, the seat 26 for the motherboard 27 is shaped so as to be laterally open, i.e. on the above indicated adjacent sides 16 and 17. More in particular, the seat 26 is laterally open for allowing, during the mounting step of the device 1, to easily insert a single motherboard 27 arranged commanding-like on plural base bodies 3, which are already placed adjacent side by side.

In practice, in the illustrated solution, the seat 26 comprises a surface, which, except for the cavity 21, is substantially flat from one side 16 to the other 17.

In substance, the side opening of the seat 26 makes, with the seat 26 of an adjacent base body 3, a so-called axially passing seat, which allows the housing of the motherboard 27 bridge-like or commanding extended between a base body 3 and the base body 3 adjacent thereto.

This allows that, in the case wherein the electronic modules 2 must e electrically interconnected, the seat 26 allows to use a single motherboard 27 bridge-like extended on all the base bodies 3, which is electrically connected with the connectors 8 of all the electronic modules 2.

It can be thus understood that, according to the present invention, the same electronic modules 2 and the same base bodies 3 can be used, and it will be necessary only to provide a predetermined motherboard 27 for them.

Remarkable examples of the above cases are respectively shown in figure 1 (twelve modules), figure 3 (four modules) and in figure 4 (two modules).

In figure 5 a single motherboard 27 comprising four connectors 28 bridge-like extends along two base bodies 3 for connecting the electronic modules 2 to the master module 2a, whereas in figure 4 the seat 26 houses a motherboard 27 having a suitable dimension for connecting only two electronic modules 2.

It goes without saying that the choice of the configuration will depend on the need of connecting a determined group of electronic modules to the same motherboard.

In order to steadily mount the motherboard 27 in the relative seat 26, the base body 3 comprises coupling pins 33 (figure 6a), two in the specific case, having substantially cylindrical shape, which are integrally made with the plate 20. The pins 33 are inserted in corresponding holes peripherally made in the motherboard 27; this also allows obtaining a predetermined insertion direction.

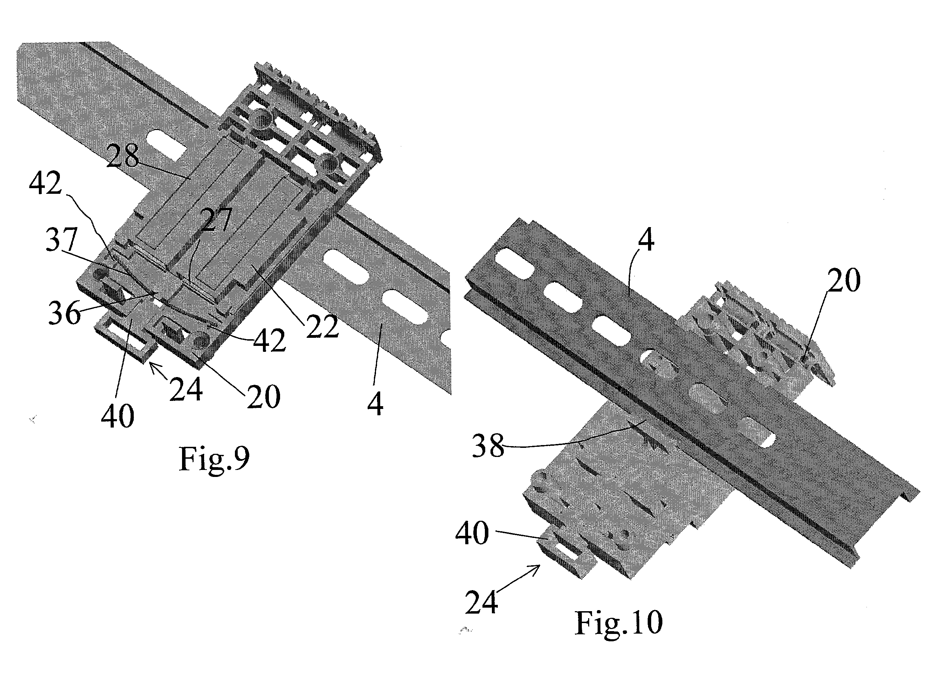

The plate 20, besides acting as container element for the motherboard 27, also allows the support of the aforesaid slide 24 for the snap fixing to the bar 4 (figures 9 and 10).

In particular, the plate 20 includes a recess 34 open towards the lower area of the device, which acts as a housing seat of the slide 24. This latter is sliding-like inserted in two side guides 35 (figurers 6, 6a), opposite to each other, which are made on the edge of the recess 34.

For allowing the attachment, the slide 24 has a first tooth 36, centrally arranged on the front side of the base body 3 and co-operating with a spring 37, a second tooth 38, arranged on the rear side, opposite to the front one (figure 10) and co-operating with the bar 4, and a handle 40 to grip the slide 24.

The spring 37 is provided to counter the grip action on the handle 40, and for this purpose, it is transversally arranged with respect to the slide 24, it is centrally attached to the tooth 36, and the two ends thereof are leaned on two respective appendixes 42 made on the plate 20.

As previously mentioned, the base body 3 comprises a casing 22 to protect the motherboard 27, but also to block it in place. In fact, the casing 22 has a form substantially conjugated to the motherboard 27, and it includes two elongated cavities 41 for the housing of the connectors 28 of the latter.

In correspondence with the cavity 41, the casing 22 also has two openings 43 having rectangular shape, which, when the casing 22 is mounted, allow the frontal surfacing of the upper surfaces of the two connectors 28 of the motherboard 27 so as to form a single flat surface therewith.

In order to steadily mount the protection casing 22 on the relative plate 22, the base body 3 comprises lower retainers 45, two in the specific case, having a substantially C-like form and two upper hooks 47, which respectively co-operate in opposite positions with the casing 22.

The lower retainers steadily hook a lower edge of the casing 22, while the upper hooks 47 snappily block an upper edge of the same casing 22, thus obtaining a steady blocking on two different levels. In particular, the upper hooks 47 are active in correspondence with the connectors 28 of the motherboard 27.

Both the lower retainers 45 and the upper hooks 47 are integrally made with the plate 20.

As regards the electronic modules 2, it is to be noted that, as the above-described base bodies, are of the modular type and the relative components are also modular by means of attachment.

As it can be noted in figure 11, the electronic module 2 comprises a box-like body 49, which is divided into a main portion 50 and a cover 51.

On the external side of this latter, in particular on two opposite sides 53 thereof, in the specific case those having smaller surface, two quick attachment teeth 55 are made, which co-operate with respective cavities 56 made in the main portion 50.

The cover 51 also includes a cavity 57, set between the two aforesaid teeth 55, for attaching a tool intended to facilitate the opening of the same cover 51.

Also provided: a light guide element 60, to move the light signals of the board 7 back to the front position, and an element 61 to delimit the connectors 9 and define a housing female seat.

It is also to be noted that, similarly to the above-described plate 20, two walls of the box-like body 49, in the specific case those of smaller surface, have a lattice structure to allow the lightening and to favour the electronic board ventilation.

The assembly components of the base bodies 3 and of the electronic modules 2, deprived of the electronic boards 7, 27, 27a and of the relative connectors 8, 9, 28, described above in the preferred embodiment, form a kit for the composition of modular electric devices.

The kit comprises: a plurality of base bodies 3, suitable for being supported adjacent side by side on a DIN module support bar 4 and each having a seat 26 for housing a first electronic board 27 or a motherboard, and a plurality of modular box-like bodies 49. Each box-like body 49 is provided for being fixed on a corresponding base body 3 and for housing at least one second electronic board 7 that can be electrically connected to the first electronic board 27. According to the invention, the seat 26 of each base body 3 is laterally open so as to axially constitute a surface continuity with the seat 26 of at least one adjacent base body 3.

The device is assembled as follows.

After placing a plurality of base bodies 3 side by side according to the function combination needs on a same device, a single motherboard 27 is housed. This latter is blocked in place and protected by the protection casing 22.

Each electronic module 2 is equipped with its own electronic board 7, and mounted on base bodies 3. It goes without saying that the modular configuration of modules 2 allows varying the electronic board 7 according to the application.

The main advantage of the present invention is that it offers a high versatility of use of the electric device to satisfy a wide range of different applications. In fact, with the same electric device 1, a plurality of electric and interconnection configurations of the electronic modules with a relative motherboard can be obtained.

Thanks to the laterally open configuration of the seat for housing the motherboard, the same base body can be in fact used with other identical and modular base bodies for housing a single motherboard 27 of a longer or shorter axial length and intended for being interconnected with several electronic modules 2.

In other words, the lateral opening of the seat 26 allows to obtain a high number of electric interconnection combinations between the electronic modules and a relative motherboard, especially in the case of electric devices comprising a considerable number of electronic modules 2, as in the case of figure 1.

This advantage is even more evident when a new electronic module, which is to be connected with the existing ones, needs to be added to a previously mounted electric device.

These simple operations are advantageously helped by the snap mounting easiness of all the components.

In fact it is to be noted from the description illustrated up to this point, that all the components of the device 1, that is the plate 20, the motherboard 27, the casing 22, the electronic modules 2, are assembled by snap hook and the use of screws or other assembly accessories is not required. This further reduces the weight and dimensions of the base bodies.

The arrangement of a single motherboard 27 also reduces the need of providing electric connectors, cables and other connection means between the motherboard and the modules, and a "space-saving" electric device with reduced weight is obtained with respect to known electronic devices.

## Claims

1. Electric device for controlling apparatuses of various types, such as systems, machines, measuring instruments, and the like, of the type comprising intended for snap mounting on a bar (4) axially extended along a determined axis (X), and comprising a plurality of base bodies (3) adjacent side by side supported on the bar (4) and each provided with a seat (26) for housing of an electronic board (27) or a motherboard, and a plurality of electronic modules (2, 2a) for electric signal processing, each one being fixed on a corresponding base body (3) and electrically connected with the relative electronic board (27) **characterised in that** the seat (26) of each base body (3) is laterally open so as to form with the seat (26) of at least one adjacent base body (3) an axially passing seat (27a) for receiving and housing said electronic board (27) bridge-like extended between the base body (3) and the adjacent base body (3).

2. Electric device according to claim 1, **characterised in that** the base body (3) includes a plate (20) wherein said seat (26) is defined.

3. Electric device according to claim 2, **characterised in that** the seat (26) comprises a substantially flat surface extending from one side (16) of the plate (20) to the other side (17) thereof.

4. Electric device according to claim 2, **characterised in that** the base body (3) comprises a slide (24) for attachment to the bar (4), said slide (24) being slidingly mounted in a recess (34) made in the plate (20).

5. Electric device according to claim 2, **characterised in that** the base body (3) includes a casing (22) to protect and block in place the motherboard (27), and quick snap means (45, 47) to attach the casing (22) to the plate (20).

6. Electric device according to claims 2, 4 and 5, **characterised in that** said plate (20), said slide (24), said casing (22) are realised in plastic material.

7. Electric device according to claim 6, **characterised in that** the plate (20) includes pins (33) integrally realised for insertion in corresponding holes in the motherboard (27).

8. Electric device according to claim 6, **characterised in that** the base body (3) comprises teeth (10) for quick attachment to the relative electronic module (2), said quick attachment teeth (10) being integrally realised with the plate (20).

9. Electric device according to claim 1, **characterised in that** the electronic module (2) is modular and it comprises a main portion (50), a cover (51) and snap attachment means (55, 56, 57) of the main portion (50) and of the cover (51).

10. Base body for a modular electric device intended for quick mounting on a support bar (4) and housing at least one pair of electronic modules (2), said base body comprising means (24, 38) for attachment to the bar (4) adjacent side by side to another base body (3) and at least one seat (26) for housing of an electronic board (27) or a motherboard, which can be electrically connected to said modules (2, 2a), **characterised in that** the seat (26) of each base body (83) is laterally open so as to constitute with the seat (26) of at least one adjacent base body (3) a seat being axially passing for housing an electronic board (27a) being bridge-like extended between the base body (3) and the adjacent base body (3).

11. Base body according to claim 10, **characterised in that** it comprises a plate (20) in plastic material containing the seat (26).

12. Base body according to claim 11, **characterised in that** the seat (26) comprises a substantially flat surface extending from one side (16) of the plate (20) to the other side (17) thereof.

13. Base body according to claim 11, **characterised in that** the plate (20) has lightening and ventilation cavities (21).

14. Base body according to claim 11, **characterised in that** the base body (3) comprises pins (33) for the insertion in conjugated holes of the motherboard (27), the pins being integrally made with the plate (20).

15. Base body according to claim 11, **characterised in that** the base body (3) comprises a slide (24) for attachment to the bar (4), the slide (24) being slidingly mounted in a recess (34) made in the plate (20).

16. Base body according to claim 15, **characterised in that** it comprises a spring (37), and that the slide (24) comprises a first tooth (36) suitable for co-operating with the spring (37), a second tooth (38) suitable for co-operating with the bar (4), and a grip handle (40) for the selective detachment of the second tooth (38) against the action of the spring (37).

17. Base body according to claim 11, **characterised in that** the base body (3) comprises a casing (22) to protect the electronic board (27), said casing having openings (43) for housing the connectors (28) of the electronic board (27).

18. Assembly kit for composing an electric control device, of the type comprising a plurality of base bodies (3) intended for an adjacent side by side snap mounting on a support bar (4) and each having a seat (26) for housing a first electronic board (27) or a motherboard, and a plurality of modular box-like base bodies (49), each arranged for being fixed to a corresponding base body (3) and for housing at least one second electronic board (7), which can be electrically connected to the motherboard (27), **characterised in that** the seat (26) of each base body (3) is laterally open so as to axially form a surface continuity with the seat (26) of at least one adjacent base body (3).
